(19)

**Europäisches Patentamt**
**European Patent Office**
**Office européen des brevets**

(11) **EP 3 905 784 B1**

(12) **EUROPEAN PATENT SPECIFICATION**

(45) Date of publication and mention
of the grant of the patent:
**25.12.2024 Bulletin 2024/52**

(21) Application number: **19904059.3**

(22) Date of filing: **25.12.2019**

(51) International Patent Classification (IPC):
*H03J 7/08* (2006.01)     *H04W 36/32* (2009.01)
*H04W 36/08* (2009.01)     *H04W 64/00* (2009.01)
*H03J 7/00* (2006.01)     *H04L 27/26* (2006.01)
*H04L 27/00* (2006.01)

(52) Cooperative Patent Classification (CPC):
**H04L 27/2657; H03J 7/08; H04L 27/0014;**
**H04L 27/2646;** H04L 2027/0026; H04L 2027/0055;
H04L 2027/0069; H04L 2027/0081; H04W 36/08;
H04W 64/006

(86) International application number:
**PCT/CN2019/128309**

(87) International publication number:
**WO 2020/135503 (02.07.2020 Gazette 2020/27)**

(54) **METHOD AND DEVICE FOR COMBATING DOPPLER SHIFT, AND COMPUTER-READABLE MEDIUM**

VERFAHREN UND VORRICHTUNG ZUR BEKÄMPFUNG EINER DOPPLERVERSCHIEBUNG UND COMPUTERLESBARES MEDIUM

MÉTHODE ET DISPOSITIF DE NEUTRALISATION D'UN DÉCALAGE DOPPLER, ET SUPPORT LISIBLE PAR ORDINATEUR

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **25.12.2018 CN 201811593569**

(43) Date of publication of application:
**03.11.2021 Bulletin 2021/44**

(73) Proprietor: **Sanechips Technology Co., Ltd.**
**Shenzhen, Guangdong 518055 (CN)**

(72) Inventor: **ZHANG, Junling**
**Shenzhen, Guangdong 518057 (CN)**

(74) Representative: **Canzler & Bergmeier**
**Patentanwälte**
**Partnerschaft mbB**
**Despag-Straße 6**
**85055 Ingolstadt (DE)**

(56) References cited:
WO-A1-2010/121453     CN-A- 101 877 687
CN-A- 101 958 744     CN-A- 102 377 474
CN-A- 105 337 693     US-A1- 2016 227 462
US-A1- 2016 345 221

## Description

The present application claims the priority from Chinese Patent Application No. 201811593569.8, filed with the Chinese Patent Office on December 25, 2018.

## TECHNICAL FIELD

Embodiments of the present disclosure relate to, but are not limited to, orthogonal frequency division multiplexing (OFDM) wireless communication technology, for example, relate to a method and device for combating Doppler shift.

## BACKGROUND

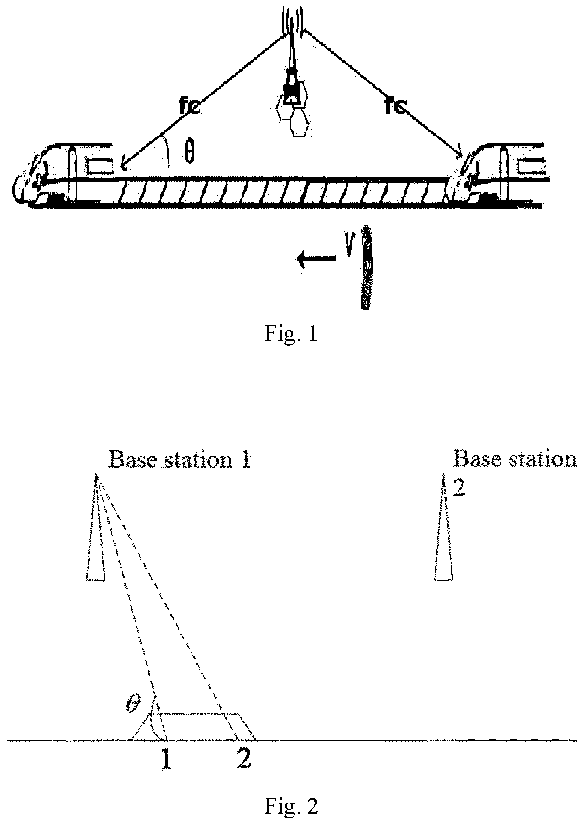

As shown in Fig. 1, in a wireless communication system, when there are a line-of-sight channel and a relative speed between a transmitter and a receiver, a Doppler shift $f_d$ will occur, and $$f_d = \frac{v}{c} * f_c * \cos(\theta)$$ . In the above equation, $v$ is the relative speed between the transmitter and the receiver, $c$ is a speed of light, $f_c$ is a carrier frequency, and $\theta$ is an angle between the transmitter and the receiver.

When a mobile client is in a high-speed moving scenario, the Doppler shift will cause serious interferences to signals.

At present, in a 4G or 5G high-speed rail communication system, a Vehicle-to-Vehicle (V2V) system, or a Vehicle-to-Everything (V2X) system, when a user-side equipment performs cell handover, there is no relevant technical solution to effectively combat the Doppler shift.

US Patent Application US2016345221A1 discloses a wireless communication system that antenna nodes are controlled to maintain a respective radio cell, each cell having one and the same physical cell identity. The antenna nodes are further controlled to maintain the respective radio cell in a single direction substantially along a path such that each wireless communication device, during movement in a movement direction along the path, can connect either to consecutive antenna nodes towards which the wireless communication device is moving or connect to consecutive antenna nodes away from which the wireless communication device is moving, so as to direct the antenna cells in certain directions in order to solve the problem that the Doppler shift is reversed at a cell handover and that this leads to instability / high complexity in the carrier frequency offset compensation until the new Doppler shift is correctly estimated.

WO Patent Application WO2010121453A1 discloses a method for correcting the frequency shift, which includes correcting the frequency of an input signal of an apparatus for correcting the frequency shift and eliminating the Doppler frequency shift in the input signal of the apparatus when an UE is confirmed in a high speed motion by a frequency shift elimination module which is located at the front-end of the AFC circuit, and receiving the output signal of the frequency shift elimination module and performing automatic frequency control according to the output signal by a AFC circuit, however, it does not mention any particular handling during handover.

## SUMMARY

The embodiments of the present application provide a method for combating Doppler shift, including: obtaining, in a case where a user equipment (UE) performs cell handover, a Doppler shift estimation of the user equipment at a last moment in a source cell; and obtaining an additive inverse of the Doppler shift estimation, and using the additive inverse of the Doppler shift estimation for Carrier Frequency Offset (CFO) compensation in an Automatic Frequency Control (AFC).

The embodiments of the present application further provide a device for combating Doppler shift, including: an obtaining unit, configured to obtain, in a case where a user equipment performs cell handover, a Doppler shift estimation of the user equipment at a last moment in a source cell; and a processing unit, configured to obtain an additive inverse of the Doppler shift estimation, and use the additive inverse of the Doppler shift estimation for CFO compensation in an AFC.

The embodiments of the present application further provide a computer-readable storage medium having an information processing program stored thereon. When the information processing program is executed by a processor, the above-mentioned method for combating Doppler shift is realized.

## BRIEF DESCRIPTION OF THE DRAWINGS

Fig. 1 is a schematic diagram of a scenario where a Doppler shift is generated.
Fig. 2 is a schematic diagram of a scenario where a Doppler shift causes interference in a 4G or 5G high-speed rail communication system.

Fig. 3 is a schematic flowchart of a method for combating Doppler shift.

Fig. 4 is a schematic structural diagram of a user-side equipment.

Fig. 5 is a schematic flowchart of a method for combating Doppler shift.

Fig. 6 is a schematic flowchart of a method for combating Doppler shift.

Fig. 7 is a schematic structural diagram of a user-side equipment.

Fig. 8 is a schematic flowchart of a method for combating Doppler shift.

Fig. 9 is a schematic structural diagram of a device for combating Doppler shift.

## DETAILED DESCRIPTION

Hereinafter, the embodiments of the present application will be described in detail with reference to the drawings. It should be noted that the embodiments in the present application and features in the embodiments can be combined with each other arbitrarily if there is no conflict.

Steps shown in a flowchart of the drawings may be executed in a computer system such as a set of computer-executable instructions. In addition, although a logical sequence is shown in the flowchart, in some cases, the steps shown or described may be performed in a sequence different from the logical sequence.

For example, as shown in Fig. 2, in a 4G or 5G high-speed rail communication system, a Doppler shift will cause the following interferences on a mobile client.

1) A Doppler shift within a cell occurs when a user terminal receives signals. At present, methods to combat this interference can adopt a suitable AFC loop and/or a Global Positioning System (GPS) signal to assist in calculating a relative movement speed when the user terminal is moving, to achieve stable AFC tracking to compensate for the Doppler shift.

2) A Doppler shift mutation occurs at a mobile client in a handover zone. As shown in Fig. 2, for example, a mobile terminal at a position 2 is in a handover zone from a base station 1 to a base station 2. Since the mobile terminal at the position 2 moves in an opposite direction relative to the base stations 1 and 2, the Doppler shift will suddenly change from a negative maximum value to a positive maximum value. At present, methods for the mobile terminal to combat this Doppler shift mutation is the same as the above-mentioned methods for combating the ordinary Doppler shift.

For the user terminal, 1) using the AFC loop can better combat the Doppler shift within a cell, but in the handover zone, a carrier frequency shift or a larger CFO estimation variance due to a low Signal to Interference plus Noise Ratio (SINR) causes a terminal to have a limited performance in tracking the Doppler shift mutation and thus leads to a decrease in a reception performance of the mobile terminal in the handover zone. 2) Using the GPS signal to assist in the calculation of the terminal's moving speed and position can better assist the mobile terminal in combating a Doppler mutation in the handover zone. For example, as shown in Fig. 2, when the mobile client enters the base station 2, the Doppler shift is obtained through GPS-assisted calculation immediately, input to a CFO estimator and output to an AFC loop filter. However, for example, for a mobile terminal user in a high-speed rail car, the GPS is shielded by a carriage and cannot be used.

In addition, in the 4G or 5G high-speed rail communication system, as shown in Fig. 2, Doppler shifts of uplink transmitted signals of multiple mobile terminals in a cell, e.g., the transmitted signals at positions 1 and 2 in Fig. 2, are inconsistent, which causes the base station to perform CFO estimation and compensation on uplink received signals one by one to combat possible ICI effects. A computational complexity of this combating method is relatively high, especially for a multiple UE uplink receiving node in a 4G or 5G V2V communication system.

Therefore, the embodiments of the present application provide a technical solution for combating Doppler shift, which can enable the user terminal to better combat the Doppler shift at smaller costs of the user terminal and the base station in different scenarios. Through an uplink CFO pre-compensation technology and a receiving-transmit AFC technology, a computational complexity of an uplink receiver is greatly reduced.

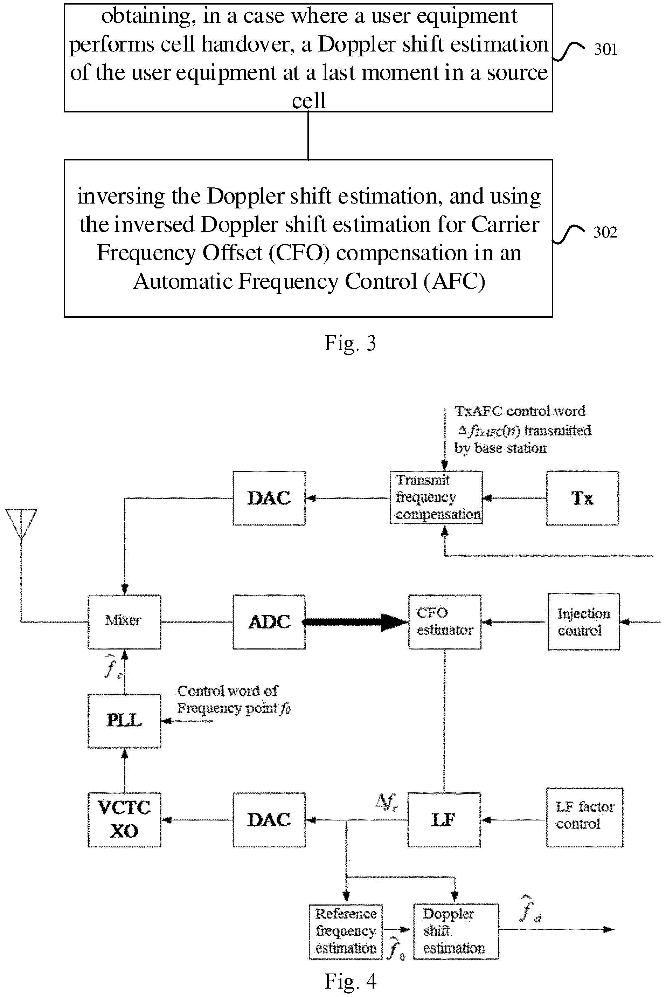

Fig. 3 is a schematic flowchart of a method for combating Doppler shift. As shown in Fig. 3, the method includes step 301 and step 302.

In step 301, when a user equipment performs cell handover, a Doppler shift estimation of the user equipment at a last moment in a source cell is obtained.

In step 302, the Doppler shift estimation is inversed, and the inversed Doppler shift estimation is used for CFO compensation in an AFC.

The step of obtaining the Doppler shift estimation of the user equipment at the last moment in the source cell, includes: determining the Doppler shift estimation at a moment when performing the cell handover according to the following equation: $\hat{f}_d(n) = \Delta f_c(n) - \Delta \bar{f}_T(n)$ .

Here, $n$ is a moment when performing the cell handover, $\hat{f}_d(n)$ is the Doppler shift estimation at the moment $n$, $\Delta \bar{f}_T$

($n$) is an average value of $\Delta f_c$ in a time period of length T before the moment n while the user equipment is in a connected state, $\Delta f_c$ is an output value of an AFC loop filter, and $\Delta f_c(n)$ is an output value of the AFC loop filter at the moment $n$.

When the user equipment is in a PC5-based ad hoc network of a V2V/V2X system, a high-precision timing of a GPS is used to calibrate the $\Delta \bar{f}_T(n)$ within time $T_1$, and a value of $T_1$ is any value from 0.1 s to 1 s.

A value of T is much larger than an average time of the user equipment in a high-speed moving state being in one cell.

The value of T is any value from 10 minutes to 30 minutes.

The step of inversing the Doppler shift estimation to be used and using the inversed Doppler shift estimation for the CFO compensation in the AFC includes: inversing the Doppler shift estimation for N times, and using the Doppler shift estimation that is inversed for N times for the CFO compensation in the AFC.

N is a natural number greater than or equal to 2, and less than or equal to 5.

The method further includes: enlarging a loop filter factor of the AFC in the user equipment.

The step of enlarging the loop filter factor of the AFC in the user equipment includes: enlarging the loop filter factor of the AFC in the user equipment by K times, for N times, i.e., enlarging the loop filter factor of the AFC in the user equipment by $K^N$ times.

When the user equipment is in a wireless mobile communication network, a value of K is any value from 1.3 to 2.

When the user equipment is in a V2V/V2X system, the value of K is any value from 1 to 1.2.

N is a natural number greater than or equal to 2, and less than or equal to 5.

The method further includes: determining an uplink transmission carrier frequency $f_T$, $f_T = \hat{f}_c - 2 * \hat{f}_d$, $\hat{f}_c = f_0 + \hat{f}_d$, $f_0$ is a downlink carrier transmit frequency, $\hat{f}_c$ is a frequency estimate of a current receiving carrier, $\hat{f}_d$ is the Doppler shift estimation, $\hat{f}_d$ is a Doppler shift, and $\hat{f}_d = \hat{f}_c - f_0$, $\hat{f}_0$ is a reference frequency estimation.

The method further includes: receiving Downlink Control Information (DCI), the DCI carrying a m-bit frequency

$$\Delta f_{TxAFC} = \begin{cases} -\alpha * \Delta f_{subcarrier}, m = 0 \\ -\beta * \Delta f_{subcarrier}, m = 1 \\ 0, m = 2 \\ \beta * \Delta f_{subcarrier}, m = 3 \end{cases}$$

adjustment value $\Delta f_{TxAFC}(n)$, and and adjusting an uplink transmission carrier frequency $f_T(n)$ according to the frequency adjustment value $\Delta f_{TxAFC}(n)$, $f_T(n) = f_T(n - 1) + \Delta f_{TxAFC}(n)$, $\Delta f_{subcarrier}$ is a subcarrier spacing of an OFDM system, and $\alpha$ and $\beta$ are preset coefficients.

The method further includes: when the user equipment is in the PC5-based ad hoc network of the V2X system, determining the transmission carrier frequency $f_T$ of a Physical Sidelink Share Channel (PSSCH), a Physical Sidelink Control Channel (PSCCH) and a Physical Downlink Shared Channel (PSDCH); where $f_T = \hat{f}_c - 2 * \hat{f}_d$, $\hat{f}_c = f_0 + f_d$, $f_0$ is the downlink carrier transmit frequency, $\hat{f}_c$ is a frequency estimate of a current receiving carrier, $f_d$ is a Doppler shift, $\hat{f}_d$ is the Doppler shift estimation, and $\hat{f}_d = \hat{f}_c - \hat{f}_0$, $\hat{f}_0$ is a reference frequency estimation; and determining a carrier frequency $f_{T,PSBCH/SLSS}(n)$ of transmitted signals of a Physical Sidelink Broadcast Channel (PSBCH) and Sidelink Synchronization Signals; where $f_{T,PSBCH/SLSS}(n) = \hat{f}_c(n) - \hat{f}_d(n)$; $n$ is a moment when performing the cell handover, $\hat{f}_d(n)$ is the Doppler shift estimation at the moment $n$, $\hat{f}_c(n)$ is a frequency estimate of a current receiving carrier at the moment n.

The technical solution provided by the present application will be described in detail below through several embodiments.

Fig. 4 is a schematic structural diagram of a user-side equipment. As shown in Fig. 4, the user-side equipment (a receiver) includes: an AFC including a mixer, a Phase Locked Loop (PLL) local oscillator circuit, a Voltage Controlled Oscillator (VCTCXO) and a Loop Filter (LF), a Digital to Analog Converter (DAC), an Analog to Digital Converter (ADC), a CFO estimator, and a TX port, etc. The mixer receives a signal with a certain frequency from a transmitter, detects a frequency error after comparing the signal with a local oscillator signal output by the PLL local oscillator circuit and outputs it to the CFO estimator for CFO estimation. The CFO outputs an estimated CFO to the LF for compensation. The LF filters out a voltage control signal and controls the VCTCXO to adjust the frequency to approximate the frequency of the received signal. The VCTCXO uses the compensated frequency signal as a local oscillator signal and feeds it back to the mixer through the PLL for frequency error detection. Then the above processes are repeated, thereby gradually reducing the frequency error between the local oscillator signal and the received signal, and realizing automatic frequency control.

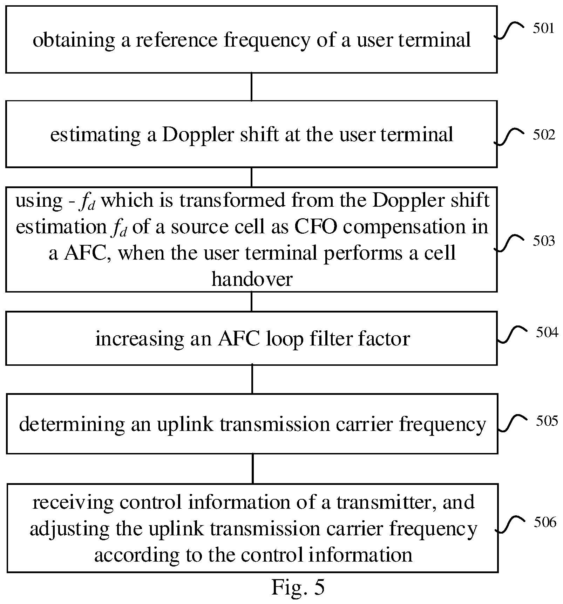

Based on the user-side equipment provided in Fig. 4, Fig. 5 is a schematic flowchart of a method for combating Doppler shift. As shown in Fig. 5, the method includes step 501 to step 506.

In step 501, a reference frequency of a user terminal is obtained.

The reference frequency is a downlink carrier transmit frequency $f_0$, and a Doppler shift $f_d$ cannot be included in a reference frequency estimation $\hat{f}_0$ obtained by a mobile terminal.

In step 502, the Doppler shift at the user terminal is estimated.

The user terminal may obtain a frequency estimate of a current receiving carrier $\hat{f}_c = f_0 + f_d$ through a downlink pilot signal, and the mobile terminal uses $\hat{f}_c$ to complete a reception for the downlink signal. It can be seen that the mobile terminal estimates the Doppler shift as $\hat{f}_d = \hat{f}_c - \hat{f}_0$.

In step 503, $-\hat{f}_d$ transformed from the Doppler shift estimation $\hat{f}_d$ of a source cell is used as CFO compensation in an AFC, when the user terminal performs a cell handover.

In the high-speed rail channel, before and after performing the handover of the mobile terminal, the Doppler shift $f_d$ will inevitably change from a negative maximum value to a positive maximum value, and a mobile client can know exactly when it enters a new cell. By using these two pieces of known information, when the user terminal enters a target cell, the Doppler shift estimation $\hat{f}_d$ of the source cell is transformed to $-\hat{f}_d$, and $-\hat{f}_d$ is input into the CFO estimator and output to the loop filter of the AFC for the CFO compensation.

In step 504, an AFC loop filter factor is increased.

By increasing the AFC loop filter factor, the AFC of the mobile terminal can quickly converge to a new mutation frequency, so as to reduce degradation for a reception performance after performing handover.

In step 505, an uplink transmission carrier frequency $f_T$ is determined.

Here,

$$ f_T = \hat{f}_c - 2 * \hat{f}_d . $$

Since Doppler shift estimations $\hat{f}_d$ of different mobile terminals already contain their respective position and speed information, for a 4G or 5G communication system using an OFDM system, the CFO compensation is generally performed in a time domain and requires a large amount of computation. In step 505, the Doppler shift of the uplink transmission carrier frequency is pre-compensated, so that transmission carrier frequencies of multiple UEs received by an uplink receiver can be substantially the same and equal to its downlink transmit frequency $f_o$, thereby omitting the calculation of CFO compensation for each UE.

If there is uplink data to be sent at this moment, the uplink data may be sent according to the determined uplink transmission carrier frequency $f_T$.

In step 506, control information of the transmitter is received, and the uplink transmission carrier frequency is adjusted according to the control information.

In an implementation, for a base station or the transmitter, if there is a reverse channel, e.g., a downlink channel in a high-speed rail communication system, the system may add an AFC control word $\Delta f_{TxAFC}(n)$ for its uplink transmit frequency in a reverse UE dedicated signaling so that an uplink receiving carrier frequency of each UE converges near $f_o$. Therefore, carrier interference (ICI) effects between UEs are further reduced. The CFO of the uplink receiving frequency of each UE needs to be estimated one by one on the uplink receiver.

If there is uplink data to be sent at this moment, the uplink data may be sent according to the determined uplink transmission carrier frequency.

**Example 1**

The Example 1 of the present application is applied to an application scenario where a user-side equipment performs a cell handover in a 4G or 5G high-speed rail communication system.

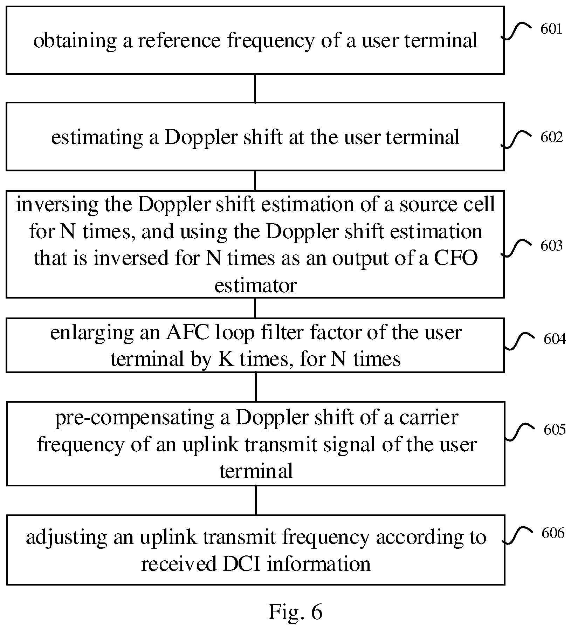

Fig. 6 is a schematic flowchart of a method for combating Doppler shift. As shown in Fig. 6, the method includes step 601 to step 606.

In step 601, a reference frequency of a user terminal is obtained.

A reference frequency estimation $\hat{f}_0$ of a certain cell is a nominal frequency of the cell frequency obtained by the user terminal through high-level signaling plus $\Delta \bar{f}_T(n)$, $\Delta \bar{f}_T(n)$ is an average value of $\Delta f_c$ in a time period of length T before a current moment n while the user terminal is in a connected state, and $\Delta f_c$ is an output value of an AFC loop filter. T must be much larger than an average time of the user terminal in a high-speed moving state being in one cell, and generally ranges from 10 to 30 minutes.

The moment n is a moment when performing cell handover.

In step 602, the Doppler shift at the user terminal is estimated.

A Doppler shift estimation of the user terminal at the current moment n is $\hat{f}_d(n) = \Delta \bar{f}_T(n) - \Delta \bar{f}_T(n)$, and $\Delta f_c(n)$ is an output value of the AFC loop filter at the moment $n$.

In step 603, the Doppler shift estimation $\hat{f}_d$ of a source cell is inversed for N times, and the inversed Doppler shift estimation is used as an output of a CFO estimator.

In an implementation, at a moment when the user terminal enters a target cell, immediately the output of the CFO estimator is forced as the last Doppler shift estimation of a previous serving cell after being inversed for N times. In this way, a AFC performs CFO compensation based on the output of the CFO estimator.

In step 604, an AFC loop filter factor of the user terminal is enlarged by K times, for N times, i.e., enlarging the loop filter factor of the AFC in the user equipment by $K^N$ times.

K is an empirical value, and generally ranges from 1.3 to 2. N is an empirical value, and generally ranges from 2 to 5. By increasing the AFC loop filter factor, the AFC of the mobile terminal can quickly converge to a new mutation frequency, so as to reduce degradation for a reception performance after performing the handover.

In step 605, a Doppler shift of a carrier frequency of an uplink transmit signal of the user terminal is pre-compensated.

When the user terminal is in the connected state, the carrier frequency of the transmit signal at the current moment $n$ is $f_T = \hat{f}_c - 2 * \hat{f}_d$. The compensation is generally performed in a digital domain.

In step 606, an uplink transmit frequency is adjusted according to received Downlink Control Information (DCI) information.

When the user terminal is in the connected state, each downlink subframe may have a DCI scheduling for a certain user terminal, and m-bit information may be added to the DCI. When the user terminal receives its own DCI information, it adjusts the uplink transmit frequency $f_T(n) = f_T(n-1) + \Delta f_{TxAFC}(n)$ according to $\Delta f_{TxAFC}(n)$ carried in the m-bit information. For example, m may be 2.

Here,

$$\Delta f_{TxAFC} = \begin{cases} -\alpha * \Delta f_{subcarrier}, m = 0 \\ -\beta * \Delta f_{subcarrier}, m = 1 \\ 0, m = 2 \\ \beta * \Delta f_{subcarrier}, m = 3 \end{cases}.$$

$\Delta f_{subcarrier}$ is a subcarrier spacing of an OFDM system, and $\alpha$ and $\beta$ are empirical values, for example, $\alpha$=0.01, and $\beta$=0.001. The compensation is generally performed in the digital domain.

## Example 2

The Example 2 of the present application is applied to an application scenario where a user-side equipment performs a cell handover in a V2V/V2X system of 4G or 5G.

The V2V/V2X system has both a uu interface-based networking method that is not much different from an ordinary Long Term Evolution (LTE) system, and an ad hoc networking method based on PC5 interfaces and using sidelink channels.

Regardless of whether a current user terminal is interacting with a base station or a certain forwarding node, in order to estimate a Doppler shift through GPS information, the user terminal must be knowledge of a current position, a movement speed and a movement direction of the user terminal, as while as being knowledge of a current position, a movement speed and a movement direction of the base station or the certain forwarding node, which leads to excessive system signaling overhead and complicated calculations of user terminal. Therefore, The Example 2 of the present application provides a solution to combat multiple Doppler shifts, which can avoid the above situation.

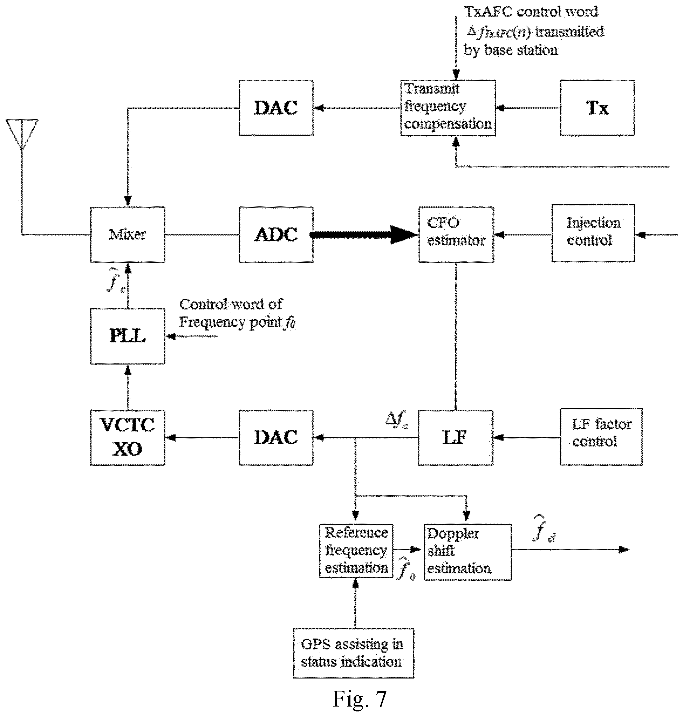

Fig. 7 is a schematic structural diagram of a user-side equipment. Fig. 7 has the same structure as Fig. 4, and will not be repeated herein.

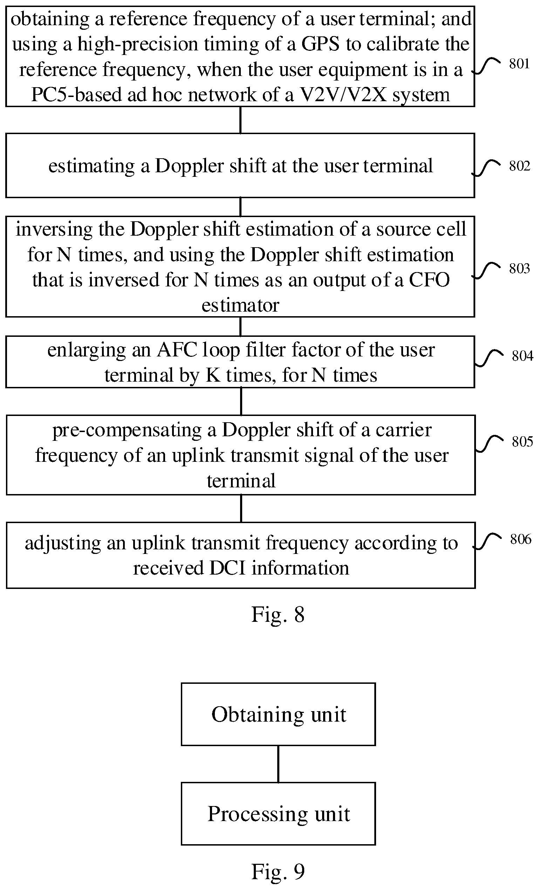

Based on the user-side equipment provided in Fig. 7, Fig. 8 is a schematic flowchart of a method for combating Doppler shift. As shown in Fig. 8, the method includes step 801 to step 806.

In step 801, a reference frequency of a user terminal is obtained.

A reference frequency estimation $\hat{f}_0$ of a certain base station or node is a nominal frequency of the cell frequency obtained by the user terminal through high-level signaling plus $\Delta \bar{f}_T(n)$, $\Delta \bar{f}_T(n)$ is an average value of $\Delta f_c$ in a time period of length T before a current moment n while the user terminal is in a connected state, and $\Delta f_c$ is an output value of an AFC loop filter. When the user terminal is connected to a base station through a uu interface, GPS may not be needed to assist in status indication. T must be much larger than an average time of the user terminal in a high-speed moving state being in one cell, and generally ranges from 10 to 30 minutes. When the user terminal is in a PC5-based ad hoc network, if the user terminal still has a reference frequency connected to the uu interface, the reference frequency is used; otherwise, a high-precision timing of the GPS is used by the user terminal to calibrate a free oscillating VCTCXO within $T_1$ time, and the calibration value is converted to the output of the AFC loop filter to form $\Delta \bar{f}_T(n)$. $T_1$ generally ranges from 0.1 s to 1 s.

In step 802, the Doppler shift at the user terminal is estimated.

A Doppler shift estimation of the user terminal at the current moment n is

$$\hat{f}_d(n) = \Delta f_c(n) - \Delta \bar{f}_T(n).$$

In step 803, the Doppler shift estimation $\hat{f}_d$ of a source cell is inversed for N times, and the inversed Doppler shift estimation is used as an output of a CFO estimator.

At a moment when the user terminal enters a target cell, immediately the output of the CFO estimator is forced as the last Doppler shift estimation of a previous serving cell that is inversed for N times. N is an empirical value, and generally ranges from 2 to 5.

In step 804, an AFC loop filter factor of the user terminal is enlarged by K times, for N times, i.e., enlarging the loop filter factor of the AFC in the user equipment by $K^N$ times.

K is an empirical value, and considering an uncertainty of the position and the movement direction of the user terminal relative to a base station of an original serving cell and a base station of the target cell under the V2V network, K generally ranges from 1.0 to 1.2.

In step 805, a Doppler shift of a carrier frequency of an uplink transmit signal of the user terminal is pre-compensated.

When the user terminal uses the uu interface to connect, the carrier frequency of the transmit signal at the current moment $n$ is $f_T = \hat{f}_c - 2 * \hat{f}_d$.

When the user terminal is in the PC5-based ad hoc network, carrier frequencies of transmit signals PSSCH, PSCCH and PSDCH at the current moment $n$ are $f_T = \hat{f}_c - 2 * \hat{f}_d$; carrier frequencies of transmit signals PSBCH and Sidelink Synchronization Signal are $f_{T,PSBCH/SLSS}(n) = \hat{f}_c(n) - \hat{f}_d(n)$. The compensation is generally performed in a digital domain.

In step 806, an uplink transmit frequency is adjusted according to received DCI information.

Only when the user terminal is connected through the uu interface, each downlink subframe may have a DCI scheduling for a certain user terminal, and m-bit information can be added to the DCI. When the user terminal receives its own DCI information, it adjusts the uplink transmit frequency $f_T(n) = f_T(n-1) + \Delta f_{TxAFC}(n)$ according to $\Delta f_{TxAFC}(n)$ carried in the m-bit information. For example, m may be 2.

Here,

$$\Delta f_{TxAFC} = \begin{cases} -\alpha * \Delta f_{subcarrier}, m = 0 \\ -\beta * \Delta f_{subcarrier}, m = 1 \\ 0, m = 2 \\ \beta * \Delta f_{subcarrier}, m = 3 \end{cases}.$$

$\Delta f_{subcarrier}$ is a subcarrier spacing of an OFDM system, and $\alpha$ and $\beta$ are empirical values. For example, $\alpha = 0.01$, and $\beta = 0.001$. The compensation is generally performed in the digital domain.

The technical solution provided by the embodiments of the present application can enable a user terminal to better combat the Doppler shift at smaller costs of user terminal and base station in different scenarios.

Fig. 9 is a schematic structural diagram of a device for combating Doppler shift. As shown in Fig. 9, the device includes an obtaining unit and a processing unit.

The obtaining unit is configured to obtain, in a case where a user equipment performs cell handover, a Doppler shift estimation of the user equipment at a last moment in a source cell.

The processing unit is configured to inverse the Doppler shift estimation, and use the inversed Doppler shift estimation for CFO compensation in an AFC.

The obtaining unit is configured to determine that $\hat{f}_d(n) = \Delta f_c(n) - \Delta \bar{f}_T(n)$.

Here, $n$ is a moment of when performing cell handover, $\hat{f}_d(n)$ is the Doppler shift estimation at the moment $n$, $\Delta \bar{f}_T(n)$ is an average value of $\Delta f_c$ in a time period of length T before the moment n while the user equipment is in a connected state, $\Delta f_c$ is an output value of an AFC loop filter, and $\Delta f_c(n)$ is an output value of the AFC loop filter at the moment $n$.

When the user equipment is in a PC5-based ad hoc network of a V2V/V2X system, a high-precision timing of the GPS is used to calibrate the $\Delta \bar{f}_T(n)$ within time $T_1$, and a value of $T_1$ is any value from 0.1 s to 1 s.

A value of T is much larger than an average time of the user equipment in a high-speed moving state being in one cell.

The value of T is any value from 10 minutes to 30 minutes.

The processing unit is configured to inverse the Doppler shift estimation for N times, and use the Doppler shift estimation that is inversed for N times for the CFO compensation in the AFC.

N is a natural number greater than or equal to 2, and less than or equal to 5.

The processing unit is further configured to enlarge a loop filter factor of the AFC in the user equipment.

The processing unit is configured to enlarge the loop filter factor of the AFC in the user equipment by K times, for N times, i.e., enlarging the loop filter factor of the AFC in the user equipment by $K^N$ times.

When the user equipment is in a wireless mobile communication network, a value of K is any value from 1.3 to 2.

When the user equipment is in a V2V/V2X system, the value of K is any value from 1 to 1.2.

N is a natural number greater than or equal to 2, and less than or equal to 5.

The device further includes a determining unit configured to determine an uplink transmission carrier frequency $f_T$.

Here, $f_T = \hat{f}_c - 2 * f_d$, $\hat{f}_c = f_0 + f_d$, $f_0$ is a downlink carrier transmit frequency, $fe$ is a frequency estimate of a current receiving carrier, $f_d$ is a Doppler shift, $\hat{f}_d$ is the Doppler shift estimation, and $\hat{f}_d = \hat{f}_c - \hat{f}_0$, $\hat{f}_0$ is a reference frequency estimation.

The device further includes a receiving unit configured to receive Downlink Control Information (DCI), the DCI carrying a m-bit frequency adjustment value $\Delta f_{TxAFC}(n)$, and

$$\Delta f_{TxAFC} = \begin{cases} -\alpha * \Delta f_{subcarrier}, m = 0 \\ -\beta * \Delta f_{subcarrier}, m = 1 \\ 0, m = 2 \\ \beta * \Delta f_{subcarrier}, m = 3 \end{cases}.$$

The device further includes an adjusting unit configured to adjust an uplink transmission carrier frequency $f_T(n)$, according to the frequency adjustment value $\Delta f_{TxAFC}(n)$, $f_T(n) = f_T(n-1) + \Delta f_{TxAFC}(n)$, $\Delta f_{subcarrier}$ is a subcarrier spacing of an OFDM system, and $\alpha$ and $\beta$ are preset coefficients.

The device further includes a determining unit.

The determining unit is configured to: determine a transmission carrier frequency $f_T$ of a PSSCH, a PSCCH and a PSDCH, when the user equipment is in a PC5-based ad hoc network of a V2X system; where $f_T = \hat{f}_c - 2 * f_d$, $\hat{f}_c = f_0 + f_d$, $f_0$ is a downlink carrier transmit frequency, $\hat{f}_c$ is a frequency estimate of a current receiving carrier, $\hat{f}_d$ is a Doppler shift, $\hat{f}_d$ is the Doppler shift estimation, and $\hat{f}_d = \hat{f}_c - \hat{f}_0$, $\hat{f}_0$ is a reference frequency estimation; and determine the carrier frequency $f_{T,PSBCH/SLSS}(n)$ of transmitted signals of a PSBCH and Sidelink Synchronization Signals; where $f_{T,PSBCH/SLSS}(n) = \hat{f}_c(n) - \hat{f}_d(n)$; $n$ is a moment when performing the cell handover, $\hat{f}_d(n)$ is the Doppler shift estimation at the moment $n$, $\hat{f}_c(n)$ is a frequency estimate of a current receiving carrier at the moment n.

The embodiments of the present application further provide a user equipment, including a memory, a processor, and a computer program stored on the memory and capable of running on the processor. The computer program is executed by the processor to realize any one of the above methods for combating Doppler shift.

The embodiments of the present application further provide a computer-readable storage medium, characterized in that an information processing program is stored on the computer-readable storage medium, and when the information processing program is executed by a processor, steps of any one of the above methods for combating Doppler shift are realized.

It should be understood by those having ordinary skill in the art that all or some of the steps in the method disclosed above, and functional modules/units in systems, and devices may be implemented as software, firmware, hardware, or suitable combinations thereof. If implemented as hardware, divisions among the functional modules/units stated above do not necessarily correspond to divisions of physical components. For example, one physical component may have a plurality of functions, or one function or step may be performed through cooperation of several physical components. Some or all of the physical components may be implemented as software executed by a processor, such as a central processing unit, a digital signal processor, or a microprocessor, or may be implemented as hardware, or may be implemented as an integrated circuit, such as an application specific integrated circuit. Such software may be distributed on computer-readable media, which may include computer storage media (or non-transitory media) and communication media (or transitory media). As well known by those having ordinary skill in the art, the term "computer storage media" includes volatile/nonvolatile and removable/non-removable media used in any method or technology for storing information (such as computer-readable instructions, data structures, program modules and other data). The computer storage media include, but are not limited to, a Random Access Memory (RAM), a Read-Only Memory (ROM), an Electrically Erasable Programmable Read-Only Memory (EEPROM), a flash memory or other memory techniques, a Compact Disc Read-Only Memory (CD-ROM), a digital versatile disk (DVD) or other optical discs, a magnetic cassette, a magnetic tape, a magnetic disk or other magnetic storage devices, or any other media which can be used to store the desired information and can be accessed by a computer. In addition, it is well known by those having ordinary skill in the art that the communication media generally include computer-readable instructions, data structures, program modules or other data in a modulated data signal, such as a carrier wave or other transmission mechanism, and may include any information delivery media.

Compared with related technologies, the embodiments of the present application provide a method and device for combating Doppler shift. The method includes: obtaining, in a case where a user equipment performs cell handover, a Doppler shift estimation of the user equipment at a last moment in a source cell; and inversing the Doppler shift estimation, and using the inversed Doppler shift estimation for CFO compensation in an AFC. Therefore, a mobile client can effectively combat Doppler shift mutations in handover zones in varies scenarios.

**Claims**

1. A method for combating Doppler shift performed by a user equipment, comprising:

   obtaining (301), in a case where a user equipment performs cell handover, a Doppler shift estimation of the user equipment at a last moment in a source cell; and
   obtaining (302) an additive inverse of the Doppler shift estimation, and using the additive inverse of the Doppler shift estimation for Carrier Frequency Offset, CFO, compensation in an Automatic Frequency Control, AFC.

2. The method according to claim 1, wherein obtaining (301) the Doppler shift estimation of the user equipment at the last moment in the source cell comprises: determining the Doppler shift estimation at a moment when performing the cell handover according to the following equation:

$$\hat{f}_d(n) = \Delta f_c(n) - \Delta \bar{f}_T(n) \; ;$$

   wherein, $n$ is the moment when performing the cell handover, $\hat{f}_d(n)$ is the Doppler shift estimation at the moment $n$, $\Delta \bar{f}_T(n)$ is an average value of $\Delta f_c$ in a time period of length T before the moment n while the user equipment is in a connected state, $\Delta f_c$ is an output value of an AFC loop filter, and $\Delta f_c(n)$ is an output value of the AFC loop filter at the moment $n$.

3. The method according to claim 2, wherein
   a high-precision timing of a Global Positioning System, GPS, is used to calibrate the $\Delta \bar{f}_T(n)$ within time $T_1$, in a case where the user equipment is in a PC5-based ad hoc network of a Vehicle-to-Vehicle, V2V/Vehicle-to-Everything, V2X, system, and a value of $T_1$ is any value from 0.1 s to 1 s.

4. The method according to claim 2, wherein a value of T is much larger than an average time of the user equipment in a high-speed moving state being in one cell.

5. The method according to claim 2, wherein the value of T is any value from 10 minutes to 30 minutes.

6. The method according to claim 1, further comprising: enlarging (504) a loop filter factor of the AFC in the user equipment.

7. The method according to claim 6, wherein enlarging the loop filter factor of the AFC in the user equipment, comprises: enlarging (604, 804) the loop filter factor of the AFC in the user equipment by $K^N$ times. wherein

   a value of K is any value from 1.3 to 2, in a case where the user equipment is in a wireless mobile communication network;
   the value of K is any value from 1 to 1.2, in a case where the user equipment is in a V2V/V2X system; and
   N is a natural number greater than or equal to 2, and less than or equal to 5.

8. The method according to claim 1, further comprising:

   determining (505) an uplink transmission carrier frequency $f_T$ ;
   wherein $f_T = \hat{f}_c - 2 * \hat{f}_d$ , $\hat{f}_c = f_0 + f_d$ , $f_0$ is a downlink carrier transmit frequency, $\hat{f}_c$ is a frequency estimate of a current receiving carrier, $f_d$ is a Doppler shift, $\hat{f}_d$ is the Doppler shift estimation, and $\hat{f}_d = \hat{f}_c - \hat{f}_0$, $\hat{f}_0$ is a reference frequency estimation.

9. The method according to claim 1, further comprising:

   receiving Downlink Control Information, DCI; wherein the DCI carries a m-bit frequency adjustment value $\Delta f_{TxAFC}$

$$\Delta f_{TxAFC} = \begin{cases} -\alpha * \Delta f_{subcarrier}, m = 0 \\ -\beta * \Delta f_{subcarrier}, m = 1 \\ 0, m = 2 \\ \beta * \Delta f_{subcarrier}, m = 3 \end{cases}$$

(n), and
; and

adjusting an uplink transmission carrier frequency $f_T(n)$, according to the frequency adjustment value $\Delta f_{TxAFC}(n)$; wherein $f_T(n) = f_T(n - 1) + \Delta f_{TxAFC}(n)$, $\Delta f_{subcarrier}$ is a subcarrier spacing of an Orthogonal Frequency-Division Multiplexing, OFDM, system, n is a moment when performing the cell handover, and $\alpha$ and $\beta$ are preset coefficients.

**10.** The method according to claim 1, further comprising:

determining a transmission carrier frequency $f_T$ of a Physical Sidelink Share Channel, PSSCH, a Physical Sidelink Control Channel, PSCCH, and a Physical Downlink Shared Channel, PSDCH, in a case where the user equipment is in a PC5-based ad hoc network of a V2X system; wherein $f_T = \hat{f}_c - 2 * f_d$, $\hat{f}_c = f_0 + f_d$, $f_0$ is a downlink carrier transmit frequency, $\hat{f}_c$ is a frequency estimate of a current receiving carrier, $f_d$ is a Doppler shift, $\hat{f}_d$ is the Doppler shift estimation, and $\hat{f}_d = \hat{f}_c - \hat{f}_0$, $\hat{f}_0$ is a reference frequency estimation; and

determining a carrier frequency $f_{T,PSBCH / SLSS}(n)$ of transmitted signals of a Physical Sidelink Broadcast Channel, PSBCH, and Sidelink Synchronization Signals; wherein $f_{T,PSBCH / SLSS}(n) = \hat{f}_c(n) - \hat{f}_d(n)$; wherein, $n$ is a moment when performing the cell handover, $\hat{f}_d(n)$ is the Doppler shift estimation at the moment n, $\hat{f}_c(n)$ is a frequency estimate of a current receiving carrier at the moment n.

**11.** A device for combating Doppler shift, comprising:

an obtaining unit, configured to obtain, in a case where a user equipment performs cell handover, a Doppler shift estimation of the user equipment at a last moment in a source cell; and
a processing unit, configured to obtain an additive inverse of the Doppler shift estimation, and use the additive inverse of the Doppler shift estimation for Carrier Frequency Offset, CFO, compensation in an Automatic Frequency Control, AFC.

**12.** A computer-readable storage medium having an information processing program stored thereon, wherein when the information processing program is executed by a processor, the method for combating Doppler shift according to any one of claims 1 to 10 is performed.

**Patentansprüche**

**1.** Verfahren zum Bekämpfen einer Doppler-Verschiebung, das von einem Benutzergerät durchgeführt wird, umfassend:

Erhalten (301), in einem Fall, in dem ein Benutzergerät eine Zellen-Übergabe durchführt, einer Doppler-Verschiebungsabschätzung des Benutzergeräts zu einem letzten Zeitpunkt in einer Ursprungszelle; und
Erhalten (302) einer additiven Umkehrung der Doppler-Verschiebungsabschätzung und Verwenden der additiven Umkehrung der Doppler-Verschiebungsabschätzung für eine Trägerfrequenzversatz-(CFO-)Kompensation in einer automatischen Frequenzsteuerung (AFC).

**2.** Verfahren nach Anspruch 1, wobei das Erhalten (301) der Doppler-Verschiebungsabschätzung des Benutzergeräts zu dem letzten Zeitpunkt in der Ursprungszelle umfasst: Bestimmen der Doppler-Verschiebungsabschätzung zu einem Zeitpunkt, wenn die Zellen-Übergabe durchgeführt wird, gemäß der folgenden Gleichung:

$$\hat{f}_d(n) = \Delta f_c(n) - \Delta \bar{f}_T(n);$$

wobei n der Zeitpunkt ist, wenn die Zellen-Übergabe durchgeführt wird, $\hat{f}_d(n)$ die Doppler-Verschiebungsabschätzung zu dem Zeitpunkt n ist, $\Delta \bar{f}_T(n)$ ein Mittelwert von $\Delta f_c$ in einer Zeitspanne der Länge T vor dem Zeitpunkt n ist, während sich das Benutzergerät in einem verbundenen Zustand befindet, $\Delta f_c$ ein Ausgangswert eines AFC-Schleifenfilters ist

und $\Delta f_c(n)$ ein Ausgangswert des AFC-Schleifenfilters zu dem Zeitpunkt n ist.

3. Verfahren nach Anspruch 2, wobei
eine hochpräzise Zeitsteuerung eines globalen Positionsbestimmungssystems (GPS) verwendet wird, um das $\overline{\Delta f_T}(n)$ innerhalb der Zeit $T_1$ zu kalibrieren, in einem Fall, in dem sich das Benutzergerät in einem PC5-basierten Ad-hoc-Netzwerk eines Fahrzeug-zu-Fahrzeug-(V2V/Vehide-to-Everything-, V2X-)Systems befindet und ein Wert von $T_1$ ein beliebiger Wert von 0,1 s bis 1 s ist.

4. Verfahren nach Anspruch 2, wobei ein Wert von T viel größer als eine durchschnittliche Zeit ist, in der sich das Benutzergerät in einem Hochgeschwindigkeits-Bewegungszustand in einer Zelle befindet.

5. Verfahren nach Anspruch 2, wobei der Wert von T ein beliebiger Wert von 10 Minuten bis 30 Minuten ist.

6. Verfahren nach Anspruch 1, ferner umfassend: Vergrößern (504) eines Schleifenfilterfaktors des AFC in dem Benutzergerät.

7. Verfahren nach Anspruch 6, wobei das Vergrößern des Schleifenfilterfaktors des AFC in dem Benutzergerät umfasst: Vergrößern (604, 804) des Schleifenfilterfaktors des AFC in dem Benutzergerät um $K^N$-Male, wobei ein Wert von K ein beliebiger Wert von 1,3 bis 2 ist, in einem Fall, in dem sich das Benutzergerät in einem drahtlosen Mobilkommunikationsnetzwerk befindet; der Wert von K ein beliebiger Wert von 1 bis 1,2 ist, in einem Fall, in dem sich das Benutzergerät in einem V2V/V2X-System befindet; und
N eine natürliche Zahl größer als oder gleich 2 und kleiner als oder gleich 5 ist.

8. Verfahren nach Anspruch 1, ferner umfassend:

Bestimmen (505) einer Uplink-Übertragungsträgerfrequenz $f_T$;
wobei $f_T = \hat{f}_c - 2 * \hat{f}_d$, $\hat{f}_c = f_0 + f_d$, $f_0$ eine Downlink-Trägerübertragungsfrequenz ist, $\hat{f}_c$ eine Frequenzabschätzung eines aktuellen Empfangsträgers ist, $f_d$ eine Doppler-Verschiebung ist, $\hat{f}_d$ die Doppler-Verschiebungsabschätzung ist und $\hat{f}_d = \hat{f}_c - \hat{f}_0$, $\hat{f}_0$ eine Referenzfrequenzabschätzung ist.

9. Verfahren nach Anspruch 1, ferner umfassend:

Empfangen von Downlink-Steuerinformationen (DCI), wobei die DCI einen m-Bit-Frequenzanpassungswert $\Delta f_{TxAFC}(n)$ tragen, und

$$\Delta f_{TxAFC} = \begin{cases} -\alpha * \Delta f_{subcarrier} , m = 0 \\ -\beta * \Delta f_{subcarrier} , m = 1 \\ 0, m = 2 \\ \beta * \Delta f_{subcarrier} , m = 3 \end{cases}$$

und
Einstellen einer Uplink-Übertragungsträgerfrequenz $f_T(n)$ gemäß dem Frequenzanpassungswert $\Delta f_{TxAFC}(n)$; wobei $f_T(n) = f_T(n - 1) + \Delta f_{TxAFC}(n)$. $\Delta f_{subcarrier}$ ein Unterträgerabstand eines orthogonalen Frequenzmultiplex(OFDM)-Systems ist, n ein Zeitpunkt ist, wenn die Zellen-Übergabe durchgeführt wird, und $\alpha$ und $\beta$ voreingestellte Koeffizienten sind.

10. Verfahren nach Anspruch 1, ferner umfassend:

Bestimmen einer Übertragungsträgerfrequenz $f_T$ eines gemeinsamen physikalischen Seitenverbindungskanals (PSSCH), eines physikalischen Seitenverbindungssteuerkanals (PSCCH) und eines gemeinsamen physikalischen Downlink-Kanals (PSDCH) in einem Fall, in dem sich das Benutzergerät in einem PC5-basierten Ad-hoc-Netzwerk eines V2X-Systems befindet; wobei $f_T = \hat{f}_c - 2 * \hat{f}_d$, $\hat{f}_c = f_0 + f_d$, $f_0$ eine Downlink-Trägerübertragungsfrequenz ist, $\hat{f}_c$ eine Frequenzabschätzung eines aktuellen Empfangsträgers ist, $f_d$ eine Doppler-Verschiebung ist, $\hat{f}_d$ die Doppler-Verschiebungsabschätzung ist und $\hat{f}_d = \hat{f}_c - \hat{f}_0$, $\hat{f}_0$ eine Referenzfrequenzabschätzung ist; und
Bestimmen einer Trägerfrequenz $f_{T,PSBCH / SLSS}(n)$ von übertragenen Signalen eines physikalischen Seitenverbindungsrundfunkkanals (PSBCH) und von Seitenverbindungssynchronisationssignalen; wobei

$f_{T,PSBCH/SLSS}(n) = \hat{f}_c(n) - \hat{f}_d(n)$; wobei n ein Zeitpunkt ist, wenn die Zellen-Übergabe durchgeführt wird, $\hat{f}_d(n)$ die Doppler-Verschiebungsabschätzung zu dem Zeitpunkt n ist, $\hat{f}_c(n)$ eine Frequenzabschätzung eines aktuellen Empfangsträgers zu dem Zeitpunkt n ist.

11. Vorrichtung zum Bekämpfen einer Doppler-Verschiebung, umfassend:

   eine Erhalteeinheit, die konfiguriert ist, um in einem Fall, in dem ein Benutzergerät eine Zellen-Übergabe durchführt, eine Doppler-Verschiebungsabschätzung des Benutzergeräts zu einem letzten Zeitpunkt in einer Ursprungszelle zu erhalten; und
   eine Verarbeitungseinheit, die konfiguriert ist, um eine additive Umkehrung der Doppler-Verschiebungsabschätzung zu erhalten,
   und die additive Umkehrung der Doppler-Verschiebungsabschätzung für eine Trägerfrequenzversatz-(CFO-)Kompensation in einer automatischen Frequenzsteuerung (AFC) zu verwenden.

12. Computerlesbares Speichermedium, auf dem ein Informationsverarbeitungsprogramm gespeichert ist, wobei, wenn das Informationsverarbeitungsprogramm von einem Prozessor ausgeführt wird, das Verfahren zum Bekämpfen einer Doppler-Verschiebung nach einem der Ansprüche 1 bis 10 durchgeführt wird.

**Revendications**

1. Procédé pour combattre un décalage Doppler réalisé par un équipement utilisateur, comprenant les étapes consistant à :

   obtenir (301), dans le cas où un équipement utilisateur réalise un transfert intercellulaire de cellule, une estimation de décalage Doppler de l'équipement utilisateur à un dernier moment dans une cellule source ; et obtenir (302) un inverse additif de l'estimation de décalage Doppler, et utiliser l'inverse additif de l'estimation de décalage Doppler pour une compensation de décalage de fréquence porteuse, CFO, dans un contrôle automatique de fréquence, AFC.

2. Procédé selon la revendication 1, dans lequel l'étape consistant à obtenir (301) l'estimation de décalage Doppler de l'équipement utilisateur au dernier moment dans la cellule source comprend l'étape consistant à : déterminer l'estimation de décalage Doppler à un moment lors de la réalisation du transfert intercellulaire de cellule selon l'équation suivante :

$$\hat{f}_d(n) = \Delta f_c(n) - \Delta \bar{f}_T(n) \, ;$$

   dans lequel, n est le moment lors de la réalisation du transfert intercellulaire de cellule, $\hat{f}_d(n)$ est l'estimation de décalage Doppler au moment n, $\Delta \bar{f}_T(n)$ est une valeur moyenne de $\Delta f_c$ dans une période de temps de longueur T avant le moment n pendant que l'équipement utilisateur est dans un état connecté, $\Delta f_c$ est une valeur de sortie d'un filtre de boucle AFC, et $\Delta f_c(n)$ est une valeur de sortie du filtre de boucle AFC au moment n.

3. Procédé selon la revendication 2, dans lequel
   une synchronisation de haute précision d'un système de positionnement global, GPS, est utilisée pour calibrer $\Delta \bar{f}_T(n)$ dans le temps $T_1$, dans le cas où l'équipement utilisateur se trouve dans un réseau ad hoc basé sur PC5 d'un système de véhicule à véhicule, V2V/véhicule à tout, V2X, et une valeur de $T_1$ est une valeur quelconque de 0,1 s à 1 s.

4. Procédé selon la revendication 2, dans lequel une valeur de T est beaucoup plus grande qu'un temps moyen de l'équipement utilisateur dans un état de déplacement à grande vitesse se trouvant dans une cellule.

5. Procédé selon la revendication 2, dans lequel la valeur de T est une valeur quelconque de 10 minutes à 30 minutes.

6. Procédé selon la revendication 1, comprenant en outre l'étape consistant à : agrandir (504) un facteur de filtre de boucle de l'AFC dans l'équipement utilisateur.

7. Procédé selon la revendication 6, dans lequel l'étape consistant à agrandir le facteur de filtre de boucle de l'AFC dans l'équipement utilisateur comprend l'étape consistant à : agrandir (604, 804) le facteur de filtre de boucle de l'AFC dans l'équipement utilisateur de $K^N$ fois, dans lequel une valeur de K est une valeur quelconque de 1,3 à 2, dans le cas où l'équipement utilisateur se trouve dans un réseau de communication mobile sans fil ;

la valeur de K est une valeur quelconque de 1 à 1,2, dans le cas où l'équipement utilisateur se trouve dans un système V2V/V2X ; et
N est un nombre naturel supérieur ou égal à 2, et inférieur ou égal à 5.

8. Procédé selon la revendication 1, comprenant en outre les étapes consistant à :

déterminer (505) une fréquence porteuse de transmission de liaison montante $f_T$ ;
dans lequel $f_T = \hat{f}_c - 2 * \hat{f}_d$, $\hat{f}_c = f_0 + \hat{f}_d$, $f_0$ est une fréquence de transmission de porteuse de liaison descendante, $\hat{f}_c$ est une estimation de fréquence d'une porteuse de réception actuelle, $f_d$ est un décalage Doppler, $\hat{f}_d$ est l'estimation de décalage Doppler, et $\hat{f}_d = \hat{f}_c - \hat{f}_0$, $\hat{f}_0$ est une estimation de fréquence de référence.

9. Procédé selon la revendication 1, comprenant en outre les étapes consistant à :

recevoir des informations de contrôle de liaison descendante, DCI, dans lequel les DCI transportent une valeur d'ajustement de fréquence de m bits $\Delta f_{TxAFC}(n)$, et

$$\Delta f_{TxAFC} = \begin{cases} -\alpha * \Delta f_{subcarrier}, & m = 0 \\ -\beta * \Delta f_{subcarrier}, & m = 1 \\ 0, & m = 2 \\ \beta * \Delta f_{subcarrier}, & m = 3 \end{cases}$$

et

ajuster une fréquence porteuse de transmission de liaison montante $f_T(n)$,
selon la valeur d'ajustement de fréquence $\Delta f_{TxAFC}(n)$ ; dans lequel $f_T(n) = f_T(n-1) + \Delta f_{TxAFC}(n)$, $\Delta f_{subcarrier}$ est un espacement de sous-porteuse d'un système de multiplexage par répartition orthogonale de la fréquence, OFDM, n est un moment lors de la réalisation du transfert intercellulaire de cellule, et $\alpha$ et $\beta$ sont des coefficients prédéfinis.

10. Procédé selon la revendication 1, comprenant en outre les étapes consistant à :

déterminer une fréquence porteuse de transmission $f_T$ d'un canal partagé de liaison latérale physique, PSSCH, d'un canal de contrôle de liaison latérale physique, PSCCH, et d'un canal partagé de liaison descendante physique, PSDCH, dans le cas où l'équipement utilisateur se trouve dans un réseau ad hoc basé sur PC5 d'un système V2X ; dans lequel $f_T = \hat{f}_c - 2 * \hat{f}_d$, $\hat{f}_c = f_0 + f_d$, $f_0$ est une fréquence de transmission de porteuse de liaison descendante, $\hat{f}_c$ est une estimation de fréquence d'une porteuse de réception actuelle, $f_d$ est un décalage Doppler, $\hat{f}_d$ est l'estimation de décalage Doppler, et $\hat{f}_d = \hat{f}_c - \hat{f}_0$, $\hat{f}_0$ est une estimation de fréquence de référence ; et déterminer une fréquence porteuse $f_{T,PSBCH/SLSS}(n)$ de signaux envoyés d'un canal de diffusion de liaison latérale physique, PSBCH, et de signaux de synchronisation de liaison latérale ; dans lequel $f_{T,PSBCH/SLSS}(n) = \hat{f}_c(n) - \hat{f}_d(n)$ ; dans lequel n est un moment lors de la réalisation du transfert intercellulaire de cellule, $\hat{f}_d(n)$ est l'estimation de décalage Doppler au moment n, $\hat{f}_c(n)$ est une estimation de fréquence d'une porteuse de réception actuelle au moment n.

11. Dispositif pour combattre un décalage Doppler, comprenant :

une unité d'obtention, configurée pour obtenir, dans le cas où un équipement utilisateur réalise un transfert intercellulaire de cellule, une estimation de décalage Doppler de l'équipement utilisateur à un dernier moment dans une cellule source ; et
une unité de traitement, configurée pour obtenir un inverse additif de l'estimation de décalage Doppler, et utiliser l'inverse additif de l'estimation de décalage Doppler pour une compensation de décalage de fréquence porteuse, CFO, dans un contrôle automatique de fréquence, AFC.

12. Moyen de stockage lisible par ordinateur sur lequel est stocké un programme de traitement d'informations, dans lequel, lorsque le programme de traitement d'informations est exécuté par un processeur, le procédé pour combattre un décalage Doppler selon l'une quelconque des revendications 1 à 10 est réalisé.

Fig. 1

Fig. 2

obtaining, in a case where a user equipment performs cell handover, a Doppler shift estimation of the user equipment at a last moment in a source cell ⟿ 301

inversing the Doppler shift estimation, and using the inversed Doppler shift estimation for Carrier Frequency Offset (CFO) compensation in an Automatic Frequency Control (AFC) ⟿ 302

Fig. 3

Fig. 4

obtaining a reference frequency of a user terminal — 501

estimating a Doppler shift at the user terminal — 502

using - $f_d$ which is transformed from the Doppler shift estimation $f_d$ of a source cell as CFO compensation in a AFC, when the user terminal performs a cell handover — 503

increasing an AFC loop filter factor — 504

determining an uplink transmission carrier frequency — 505

receiving control information of a transmitter, and adjusting the uplink transmission carrier frequency according to the control information — 506

Fig. 5

obtaining a reference frequency of a user terminal  ⌇⌐ 601

estimating a Doppler shift at the user terminal  ⌇⌐ 602

inversing the Doppler shift estimation of a source cell for N times, and using the Doppler shift estimation that is inversed for N times as an output of a CFO estimator  ⌇⌐ 603

enlarging an AFC loop filter factor of the user terminal by K times, for N times  ⌇⌐ 604

pre-compensating a Doppler shift of a carrier frequency of an uplink transmit signal of the user terminal  ⌇⌐ 605

adjusting an uplink transmit frequency according to received DCI information  ⌇⌐ 606

Fig. 6

Fig. 7

| obtaining a reference frequency of a user terminal; and using a high-precision timing of a GPS to calibrate the reference frequency, when the user equipment is in a PC5-based ad hoc network of a V2V/V2X system | ∿ 801 |

| estimating a Doppler shift at the user terminal | ∿ 802 |

| inversing the Doppler shift estimation of a source cell for N times, and using the Doppler shift estimation that is inversed for N times as an output of a CFO estimator | ∿ 803 |

| enlarging an AFC loop filter factor of the user terminal by K times, for N times | ∿ 804 |

| pre-compensating a Doppler shift of a carrier frequency of an uplink transmit signal of the user terminal | ∿ 805 |

| adjusting an uplink transmit frequency according to received DCI information | ∿ 806 |

Fig. 8

| Obtaining unit |

| Processing unit |

Fig. 9

**EP 3 905 784 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201811593569
- US 2016345221 A1
- WO 2010121453 A1